Europäisches Patentamt

European Patent Office

Office européen des brevets

(19)

(11) Veröffentlichungsnummer : **0 010 712**
**B1**

(12) **EUROPÄISCHE PATENTSCHRIFT**

(45) Veröffentlichungstag der Patentschrift :
22.09.82

(21) Anmeldenummer : 79104078.5

(22) Anmeldetag : 22.10.79

(51) Int. Cl.³ : **H 05 K   9/00, H 01 B ˙ 5/14,
G 01 R   1/18, A 41 D  13/00,
A 41 D 31/00**

(54) Verwendung von metallisierten textilen Flächengebilden als Strahlenschutz gegen Mikrowellen.

(30) Priorität : 02.11.78 DE 2847486

(43) Veröffentlichungstag der Anmeldung :
14.05.80 (Patentblatt 80/10)

(45) Bekanntmachung des Hinweises auf die Patenterteilung : 22.09.82 Patentblatt 82/38

(84) Benannte Vertragsstaaten :
AT BE CH DE FR GB IT LU NL

(56) Entgegenhaltungen :
DE A 2 000 195
DE A 2 002 458
DE A 2 329 484
DE A 2 528 189

(73) Patentinhaber : BAYER AG
Zentralbereich Patente, Marken und Lizenzen
D-5090 Leverkusen 1, Bayerwerk (DE)

(72) Erfinder : Ebneth, Harold, Dr.
Berta-von-Suttner-Strasse 61
D-5090 Leverkusen 1 (DE)
Erfinder : Fitzky, Hans-Georg, Dr.
Kolpingstrasse 7
D-5068 Odenthal (DE)

Verwendung von metallisierten textilen Flächengebilden als Strahlenschutz gegen Mikrowellen

Die Erfindung richtet sich auf die Verwendung von metallisierten textilen Flächengebilden zur breitbandigen Abschirmung von Mikrowellen- und Hochfrequenzstrahlung im Bereich von 0,01 bis 100 GHz.

Wegen gerätetechnischer Fortschritte und der guten Bündelbarkeit sind heute bei Mikrowellenstrahlung Leistungsdichten von 10 W/cm$^2$ erreichbar. Bei vielen neuen Einsatzmöglichkeiten hat auch der Strahlenschutz gegen hochfrequente elektromagnetische Wechselfelder an Bedeutung gewonnen (P. Brodeur « The Zapping of America », W.W. Norton & Co., Inc., New York, 1977). Eine Strahlenbelastung des menschlichen Körpers von 10 bis 20 mW/cm$^2$ wird als Obergrenze angesehen. Es ist auch schon empfohlen worden, daß bei Langzeitbestrahlungen die Bestrahlung 1 mW/cm$^2$ nicht überschritten werden sollte.

Es sind daher Abschirmmaterialien erforderlich, die die elektromagnetischen Wellen beim Durchtritt wirkungsvoll schwächen müssen. Bei Meßgeräten können noch höhere Schirmdämpfungen erforderlich sein. Der Frequenzbereich der heute überwiegend verwendeten Mikrowellengeräte reicht von 1 bis 30 GHz ; es ist damit zu rechnen, daß Mikrowellenstrahlung bis 1 000 GHz verwendet wird.

Grundsätzlich lassen sich Mikrowellen beim Druchtritt durch kompaktes metallisches Material abschirmen. Es ist jedoch gerade für den Strahlenschutz des Menschen und spezielle technische Anwendungen wünschenswert, ein leichtes flexibles Abschirmmaterial zu haben. Selbst ein Gewebe aus reinen Metallfäden ist schwer und nicht flexibel. Gewirke und Gestricke sind aus Metallfäden nicht herstellbar.

Die in der deutschen Offenlegungsschrift 23 29 484 beschriebenen Fasern dienen zum Ausschalten der störenden Wirkung der statischen Elektrizität. Es ist dort angegeben, daß die Fasern einen spezifischen elektrischen Widerstand von 10$^2$ bis 10$^5$ Ohm/cm erreichen können. Damit liegt der Widerstand nach DIN 54 345 einer 1 μm dicken Schicht zwischen 10$^9$ und 10$^5$ Ohm. Das reicht zur Ausschaltung der störenden Wirkung der statischen Elektrizität aus ; wenn ein solches metallisiertes Flächengebilde für den Stahlschutz eingesetzt werden soll, müßte die Leitfähigkeit mindestens 4 Größenordnungen höher sein. Wenn trotzdem in diesem Dokument angegeben wird, daß aus den erfindungsgemäßen Fasern hergestellte Stoffe als bequeme Abschirmstoffe zum Abschirmen störender elektromagnetischer Wirkungen verwendet werden können, da insbesondere bei 9 GHz die Reflektion 99,8 % betragen soll, so ist das nicht glaubhaft. Für die Dämpfung der Strahlung ist weniger die Absorption als vielmehr die Reflektion mit niedriger Oberflächenimpedanz entscheidend. Der Oberflächenwiderstand muß klein gegenüber dem Wellenwiderstand (Fernfeld) des Raumes von 377 Ohm sein. Wenn aber der kleinste Wert eines Widerstandes mindestens 10$^5$ Ohm beträgt, ist die behauptete hohe Reflektion ausgeschlossen.

In dem in der deutschen Offenlegungsschrift 25 28 189 beanspruchten gewirkten oder gewebten Tuch sind neben stromlos mit Metall beschichteten Stapelfasern metallische Fäden eingearbeitet. Ohne den zusätzlich unbedingt erforderlichen Einbau von Metallfäden kann die nötige Leitfähigkeit nicht erreicht werden.

Bei der Herstellung leitfähiger textiler Flächengebilde nach den deutschen Offenlegungsschriften 20 02 458 oder 23 29 484 muß vom beschichteten Faden ausgegangen werden, weil es bei einer Metallisierung des textilen Flächengebildes zu einer Verklebung kommen würde und dabei der textile Charakter verloren gehen würde.

Aufgabe der Erfindung ist ein Abschirmmaterial für Mikrowellen- und Hochfrequenzstrahlung, das die Strahlung in Transmission wirkungsvoll abschwächen kann, dabei flexibel ist, weitgehend textilelastische Eigenschaften hat und nicht zu schwer ist. Diese Aufgabe wird von metallisierten textilen Flächengebilden aus synthetischen Polymeren oder nativen Fasern, die senkrecht zur Abschirmungsrichtung Öffnungen mit Weiten kleiner als die halbe Wellenlänge der abzuschirmenden Strahlung aufweisen, gelöst, wobei das Metall nach Aktivierung der textilen Flächengebilde auf diesen mit einer Metallschichtdicke auf dem Monofil zwischen 0,02 und 2 μm naßchemisch stromlos niedergeschlagen worden ist, und gegebenenfalls galvanisch weiter verstärkt werden kann.

Gegenstand der Erfindung ist die Verwendung von metallisierten textilen Flächengebilden zur Abschirmung von Mikrowellen- und Hochfrequenzstrahlung.

In einer speziellen Ausführungsform besteht die Metallschicht aus Nickel, Kobalt, Kupfer, Silber, Gold, auch in Kombination oder als Legierung. Das textile Flächengebilde besteht vorzugsweise aus Polyurethan, PVC, Polyolefin, Modacryl, Viskose, Polyester, Aramid, Polyamid, Polyacrylnitril, Baumwolle, allein oder auch untereinander kombiniert.

In einer besonderen Ausführungsform ist das metallisierte textile Flächengebilde dadurch gekennzeichnet, daß die metallisierten Fasern, Fäden, Schnüre oder textilen Flächengebilde nach ihrer Metallisierung auf mehrere Lagen verteilt sind und isolierende Zwischenlagen oder oberflächliche Kaschierungen oder Bedeckungen aus nicht-metallisierten Geweben, Folien oder Lackierungen zwischen den einzelnen metallisierten Schichten vorhanden sind.

In einer speziellen Ausführungsform hat das textile Flächengebilde isotrope Eigenschaften ; in einer weiteren speziellen Ausführungsform hat das textile Flächengebilde anisotrope Eigenschaften.

In einer speziellen Ausführungsform ist auf der naßchemisch, stromlos niedergeschlagenen Metallschicht eine weitere Metallschicht galvanisch aufgebracht worden.

Gegenstand der Erfindung ist besonders die Verwendung von metallisierten textilen Flächengebilden als Strahlungsschutz im medizinischen und nachrichtentechnischen Bereich, als Dichtungsprofil zur elektrischen Abdichtung von mehrteiligen Metallgehäusen und zur Abschirmung von Räumen.

Das Material ist geeignet zur Abschirmung von Hochfrequenz- und Mikrowellenstrahlung von 0,01 bis mindestens 1 000 GHz. Der umfaßte Frequenzbereich ist also größer als der Bereich, der heute üblicherweise mit Mikrowellenstrahlung umschrieben wird.

Es hat sich gezeigt, daß die Art der Metallisierung von entscheidendem Einfluß auf die Wirkung des elastischen metallisierten Materials als Abschirmung ist. Wird ein elastisches Material verwendet, das nur mit Metall bedampft ist, so sind die Gebrauchseigenschaften und die Haltbarkeit der Metallschicht auf dem Substrat gering. Überraschend hat es sich jedoch gezeigt, daß die nach unserem Verfahren erzeugte Metallschicht, die Einzelfilamente völlig umschließt, jedoch das textile Flächengebilde, z.B. Webware, Maschenware, Vliese, in seiner elastischen Eigenschaft nicht mindert. Jede Einzelfaser bleibt auch im metallisierten Zustand ein von der anderen Faser unabhängiges Individuum. Merkwürdigerweise tritt keine Verschmelzung der Einzelfasern beim Metallisierungsvorgang ein, die eine Versteifung des textilen Flächengebildes zur Folge hätte. Im Gegensatz zur Bedampfung ist auch ein gleichmäßiges Durchdringen des Substrates mit der Metallschicht selbst bei Vliesen, Filzen und voluminösen Gestricken gewährleistet.

Die Metallschichtdicke auf dem Monofil soll zwischen 0,02 µm und 2 µm liegen. Der Oberflächenwiderstand, gemessen nach DIN 54 345 bei 23 °C und 50 % rel. Feuchte, liegt bei einer Nickelschichtdicke von 0,10 µm bei größenordnungsmäßig $10^2$ Ohm.

Es geht die Struktur des textilen Flächengebildes, also besonders der textile Aufbau, in das Absorptionsverhalten ein. Grundsätzlich können textile Flächengebilde in jeder Konstruktion vorliegen, z.B. in Leinwand-, Köper-, Krepp- oder in einer anderen Bindung. Bei der Wahl des textilen Flächengebildes sind einerseits Anwendungsbedingungen zu erfüllen, die nicht unbedingt mit der Absorption für Mikrowellen zusammenhängen, wie das Gewicht oder die Festigkeit, es sind aber auch Eigenschaften des Materials zu berücksichtigen, die direkt das Abschirmverhalten beeinflussen. Von besonderer Bedeutung ist dabei die Maschengröße und -form. Die Maschenbreite muß kleiner als die halbe Wellenlänge der abzuschirmenden Strahlung sein ; bevorzugt ist ein Material, wo die Größe der Maschen 1-10 % der Wellenlänge nicht überschreitet. Die Abschirmwirkung hängt außerdem von der Form der Maschen ab. Man wird daher eine möglichst isotrope textile Konstruktion wählen, wenn die Abschirmwirkung isotrop sein soll. Andererseits läßt sich durch Verspannen eines lockeren grobmaschigeren textilen Gebildes erreichen, daß die Mikrowellenstrahlung nach dem Durchtritt durch dieses Material teilweise polarisiert ist, wenn unpolarisierte Strahlung einfällt, bzw. ist bei linear polarisierter Strahlung die Abschirmwirkung besonders groß, wenn die mechanische Spannung und der Vektor der elektrischen Feldstärke aufeinander senkrecht stehen.

Neben der Maschenweite ist bezüglich der Abschirmwirkung die räumliche Tiefe (Dicke) des Gewebes, Gestrikkes, Vlieses oder Filzes von Bedeutung. Die Abschirmwirkung wird mit steigender Dicke wesentlich verbessert.

Von besonderem Interesse sind hier auch Kontruktionen, die bei wirtschaftlichem Metalleinsatz eine möglichst große Abschirmwirkung erzielen. Die allgemeinen Konstruktionsprinzipien folgen den Richtlinien für sog. Wabengitter oder Wabenkaminfenster, die für die Abschirmung von Räumen benutzt werden, wobei gleichzeitig ein Höchstmaß von Luft- und Lichtdurchlässigkeit erzielt werden soll (s.a. Handbuch für Hochfrequenz- und Elektrotechniker, Bd. III, S. 913 ff, Herausgeber C. Rint, Verlag für Radio-Foto-Kinotechnik GmbH, Berlin-Borsigwalde 1957). Querschnitt und räumliche Tiefe der Einzelmasche, deren räumliche Staffelung, Leitfähigkeit, Permeabilität und Schichtdicke der verwendeten Metalle tragen in unterschiedlicher Weise zur Abschirmung bei. Gegenüber den dort beschriebenen Abschirmmaterialien (Lochbleche, Metallgitter) bieten die metallisierten textilen Flächengebilde den Vorteil der vollen textiltechnischen Eigenschaften (Flexibilität, Elastizität, Trageverhalten, Reinigungsmöglichkeit und des erheblich geringeren Metalleinsatzes, Gewicht), womit grundsätzlich neue Anwendungsgebiete erschlossen werden (Personenschutz, Emissionsschutz, Dichtungsprofile).

Physikalisch gesehen erfolgt die Transmission der Wellen innerhalb der Einzelmasche in einem Rohr- oder Hohlleiter. Die Übertragungseigenschaft eines Rohrleiters hat eine Hochpaßcharakteristik, d.h. unterhalb einer durch die größte Querdimension (Maschenweite) bestimmten Wellenlänge ist eine Transmission möglich (s.o.g. Handbuch, S 443 ff.). Im Sperrbereich steigt die Dämpfung (Abschirmwirkung) mit wachsender Länge des Rohrleiters (Dicke des Gewebes) und mit fallendem Querschnitt (Maschenweite). Damit eine hohe Abschirmwirkung innerhalb eines gegebenen Wellenlängenbereiches resultiert, muß eine Maschenweite von weniger als etwa der halben Wellenlänge und außerdem die Dikke des textilen Flächengebildes hinreichend groß gewählt werden. Wenn die Maschenweite kleiner als die Dicke ist, steigt die Abschirmwirkung proportional der Dicke an. Bei geringer Dicke des Materials (Maschengröße größer als die Dicke) kann bezüglich des Abschirmeffekts nicht mehr das Rohrleitermodell zur Erklärung herangezogen werden. In solchen Fällen tritt ein räumlicher Durchgriff des Strahlungsfeldes durch die Masche auf.

Man kann die Abschirmwirkung durch die Verkleinerung des Maschenquerschnitts auf 1 % und

## 0 010 712

weniger der Wellenlänge verbessern. Es besteht jedoch auch die Möglichkeit der Hintereinanderschaltung textiler Flächengebilde. Um den Durchgriff des Feldes, das eine Reichweite von der Größe der Maschenweite aufweist zu reduzieren, sollte die zweite Schicht des metallisierten textilen Flächengebildes nicht direkt auf der ersten Schicht aufliegen, sondern eine nichtmetallische Schicht (Folie, nicht metallisiertes Gewebe) dazwischen geschaltet sein. Eine solche Kombination hat gegenüber einem einfachen textilen Flächengebilde mit entsprechend dickerer Metallschicht bei gleicher Abschirmwirkung eine wesentlich bessere Flexibilität und Elastizität. Bei relativ niedrigen Frequenzen (< 100 MHz) ist dieser mehrlagige Aufbau besonders bevorzugt.

Verallgemeinernd läßt sich sagen, daß die Metallschichtdicke mindestens den Wert der Skin-Tiefe haben sollte (das ist die Länge bei der die Intensität des elektromagnetischen Feldes auf den 1/e-ten Teil des Wertes an der Oberfläche abgeklungen ist). Bei Frequenzen um 10 GHz und Metallen wie Nickel oder Gold liegt die Skintiefe bei 1 $\mu$m. Ist die Bedingung für die Metallschichtdicke erfüllt, beeinflußt die Konstruktion des Gewebes am stärksten die Eignung des metallisierten textilen Flächengebildes als Abschirmmaterial. Um besonders im Frequenzbereich zwischen 10 und 1 000 MHz eine hohe Abschirmung zu erreichen, ist die Verwendung dickerer Gewebe, Gestricke, Gewirke, Vliese erforderlich, gelegentlich auch eine Anordnung mit mehreren Schichten.

Beschreibung der Meßanordnung

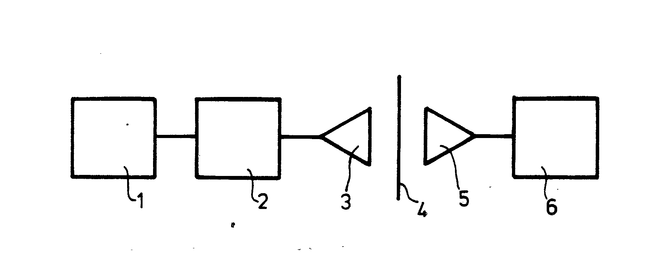

Die Abschirmwirkung der metallisierten textilen Flächengebildes wird durch Messung der Absorption in Transmission ermittelt. Die Meßschaltung ist in der Figur dargestellt. Die elektromagnetische Strahlung wird im Meßsender 1 erzeugt und über einen geeichten Abschwächer 2 einer Hornantenne 3 zugeführt. Das zu messende Objekt 4 wird in den Strahlengang zwischen Sender 3 und Empfangsantenne 5 gestellt ; es kann senkrecht und schräg durchstrahlt werden. Wenn bei den folgenden Schwächungswerten nichts anderes erwähnt ist, ist stets senkrecht durchstrahlt worden ; die Abschirmwirkung ist dabei am kleinsten.

Die Empfangsfeldstärke an der Hornantenne 5 wird am Detektor 6 angezeigt. Das verwendete Meßverfahren ist in H. Groll, Mikrowellenmeßtechnik, F. Vieweg & Sohn, Braunschweig, 1969, 326 f. unter der Bezeichnung « Hochfrequente Substitution » beschrieben. Der direkt in dB geeichte Dämpfungsregler 2 wird so verändert, daß der Detektor ohne Objekt den gleichen Anschlag wie mit Meßobjekt bei entsprechend höherer Sendeleistung, d.h. kleinerer Abschwächung, zeigt.

Zur Eliminierung des Effekts stehender Wellen im Bereich vor und hinter dem Meßobjekt (Grenzflächenreflexion) wird eine breitbandig frequenzmodulierte Strahlung konstanter Leistung, z.B. 1,7-2,4 GHz oder 7-8 GHz verwendet.

Beispielsweise Beschreibung der Metallisierung textiler Flächengebilde.

Ein textiles Flächengebilde, z.B. Webware, Maschenware, Vliese, aus Chemiefasern oder nativen Fasern wird bei Raumtemperatur in ein salzsaures Bad (pH $\leq$ 1) einer kolloidalen Palladiumlösung gemäß DE-AS 1 197 720 eingetaucht. Nach Verweilen unter leichter Warenbewegung bis etwa 3 Minuten, wird das Gut entnommen und mit Wasser bei Raumtemperatur gespült. Dann gibt man es etwa 1,5 Minuten in eine ca. 5 %ige Natronlauge, oder 10 %ige Sodalösung oder 5 %ige Schwefelsäure oder 20 %ige Salzsäure bei Raumtemperatur, spült ca. 30 Sekunden mit Wasser und trägt es anschließend in ein handelsübliches stromloses Vernickelungsbad bzw. Verkupferungs- oder Vergoldungsbad.

a) Vernickelung

Das Nickelbad kann bestehen aus 0,2 Mol/l Nickel-II-chlorid, 0,9 Mol/l Ammoniumhydroxid, 0,2 Mol/l Natriumhypophosphit, in das man so viel Ammoniak einleitet, daß der pH-Wert bei 20 °C ca. 9,5-9,6 beträgt. Bereits nach 10 Sekunden beginnt sich die Probe dunkel unter Metallabscheidung zu verfärben. Nach 20 Sekunden schwimmt die Probe auf unter Wasserstoffgasentwicklung und ist völlig mit Nikkel bedeckt.

Als Nickelsalz kann auch Nickelsulfat und als Reduktionsmittel Dimethylaminbroan gewählt werden. Auch Abscheidungen unter erhöhter Temperatur und Verwendung bekannter ionogener Systeme z.B. Zinnchlorür, Palladiumchlorid sind möglich.

b) Verkupferung

Zur Verkupferung haben sich folgende bekannte Bäder als geeignet erwiesen :

30 g/l Kupfersulfat werden mit 100 g/l Seignettesalz und 50 ml/l 37 Gew.-%ige Formaldehydlösung gemischt und mit Natronlauge auf pH 11-12 eingestellt.

Nach 20 Sekunden beginnt sich die Oberfläche des aktivierten Gutes unter Kupferabscheidung und Wasserstoffgasentwicklung zu verfärben. Nach 20 Minuten hat sich eine Kupferschicht von ca. 0,8 $\mu$m auf der Faseroberfläche abgeschieden. Nach reichlichem Spülen trocknet man schonend, um eine Oberflächenoxidation der Kupfers zu vermeiden.

c) Vergolden

Auf eine etwa 0,2 µm starke Kupferschicht, wie unter b) hergestellt, kann man bei etwa 70 °C unter Verwendung bekannter alkalischer Goldbäder direkt metallisches Gold abscheiden, um oberflächenvergoldete textile Flächengebilde zu erhalten.

Die allgemein beschriebenen Eigenschaften sind in den folgenden Beispielen zahlenmäßig belegt.

### Beispiel 1

Mit Schichtdicken zwischen 0,15 und 0,75 µm lassen sich im Frequenzbereich zwischen 1,7 und 24,5 GHz Schwächungen zwischen 9 und mehr als 40 dB erreichen.

| Schichtdicke in µm | Frequenzbereich in GHz | | | |
|---|---|---|---|---|
| | 1,7–2,4 | 7–8 | 11–12 | 23–24,5 |
| 0,15 | 9 (10,5) | 13 (13) | 12 (13) | 16,5 (16,5) |
| 0,16 | 11 (14) | 14 (15) | 15 (16) | 18,5 (18,5) |
| 0,20 | 16 (18) | 16 (18) | 16 (18,5) | 20 (21) |
| 0,28 | 19 (19) | 21,5 (22,5) | 19 (21) | 21,5 (23) |
| 0,38 | 26 (26) | 24 (26) | 23 (24) | 22,5 (24) |
| 0,40 | >28 (>28) | 33 (33) | 32 (32) | 34 (34) |
| 0,75 | >40 (>40) | >40 (>40) | >40 (>40) | >40 (>40) |

Es handelt sich um eine Nickelschicht auf einem 100 % Polyacrylnitril-Filamentgarngewebe (Klopf-Filtergewebe) mit einem Flächengewicht von 152 g/m². Die textiltechnische Konstruktion ist wie folgt : Kette und Schuß : 238 dtex aus dtex 220 f 96 Z 150, mit 38,5 Kettfäden pro cm und 27 Schußfäden pro cm, Bindung : Köper 2/2. Das Filamentgarngewebe ist wie oben beschrieben vernickelt. Die in der Tabelle angegebenen Zahlenwerte sind die aus Transmissionsmessungen linear polarisierten Strahlungen erhaltenen Dämpfungswerte in dB. Zu einer Messung gehören jeweils 2 Werte. Der Wert in Klammern wird erhalten, wenn das Gewebe in der Objektebene um 90° gedreht worden ist. Es soll damit angedeutet werden, wie groß die Anisotropie der Absorption bei dem Metall ist.

### Beispiel 2

Bei einem hochvolumigen grobmaschigen Gestrick lassen sich bei Schichtdicken um 0,15 µm Schwächungswerte über 40 dB erreichen.

| Schichtdicke in µm | Frequenzbereich in GHz | | | |
|---|---|---|---|---|
| | 1,7–2,4 | 7–8 | 11–12 | 23–24,5 |
| 0,12 | 20 (13,5) | 23,5 (37) | 33 (38) | 36,5 (36,5) |
| 0,14 | 21,5 (17) | 30 (45) | 36 (47) | 47 (>47) |
| 0,16 | 32 (35,5) | 36,5 (45) | 36,5 (47) | 42 (>47) |

Es handelt sich hier wiederum um Nickelschichten auf einem grobmaschigen Flachstrick 2,5 englische Teilung, Bindung : Fang mit 1 : 1-Nadelzug.

### Beispiel 3

Einfluß der Maschengröße auf die Absorption. Es handelt sich um ein sehr grobes Spinnfasergewebe ; die Absorption nimmt bei höheren Frequenzen ab.

| | Frequenzbereich in GHz | | | |
|---|---|---|---|---|
| | 1,7–2,4 | 7–8 | 11–12 | 23–24,5 |
| Schwächung in dB | >28 (>28) | 21 (24) | 17,5 (21) | 13 (17) |

Die Nickelschichtdicke ist hier 0,38 μm. Das Spinnfasergewebe ist in Leinwandbindung mit großer Maschenbreite, Garnnummer Nm 8 in Kette und Schuß (50,4 Kettfäden/10 cm ; 42,2 Schußfäden/10 cm, Leinwandbindung 1/1).

## Beispiel 4

Bei einem sehr dichten Spinnfasergewebe ist die Absorption wenig von der Frequenz abhängig.

| Schichtdicke in μm | Frequenzbereich in GHz | | | |
|---|---|---|---|---|
| | 1,7–2,4 | 7–8 | 11–12 | 23–24,5 |
| 0,19 | 17 (21) | 19 (21) | 17 (18,5) | 19,5 (20,5) |
| 0,38 | 28 ( 28) | 26,5 (27,5) | 27 (27,5) | 25 (26) |

## Beispiel 5

Einfluß der mechanischen Spannung auf die Absorption (Dehnungsanisotropie).

Die Messung erfolgt wieder bei linear polarisierter Strahlung. Zu jedem Zahlenpaar Schichtdicke/Frequenzbereich gehören 6 Absorptionswerte in dB. Die Werte in der jeweils ersten Zeile sind bei unverspanntem Gewebe ermittelt. Bei den Werten in der 2. Zeile, gekennzeichnet durch S′, liegt eine Spannung parallel zu den Strickrippen ; bei den Werten in der 3. Zeile, gekennzeichnet durch S, liegt eine Spannung senkrecht zu den Strickrippen. Bei den Werten ohne Klammer ist der E-Vektor der Strahlung senkrecht zu den Strickrippen ; bei den Werten in Klammern ist der E-Vektor parallel zu den Strickrippen ausgerichtet.

| Nickel-Schichtdicke in μm | | Frequenzbereich in GHz | | | |
|---|---|---|---|---|---|
| | | 1,7–2,4 | 7–8 | 11–12 | 23–24,5 |
| 0,12 | | 20,5 (13,5) | 23,5 (37) | 33 (38) | 36,5 (36,5) |
| 0,12 | S′ | 17 (16) | 29 (35) | 23,5 (38) | 24,5 (38) |
| 0,12 | S | 22,5 (14) | 25,3 (24) | 34,5 (25) | 40 (26) |
| 0,14 | | 21,5 (17) | 30 (45) | 36 (47) | 47 (>47) |
| 0,14 | S′ | 19,5 (20) | 40 (>47) | 37,5 (47) | 32,5 (39) |
| 0,14 | S | 16 (18) | 30,5 (30) | 37 (29,5) | 42 (30) |
| 0,16 | | 32 (35,5) | 36,5 (45) | 36,5 (47) | 42 (>47) |
| 0,16 | S′ | 36 (>40) | 35 (47) | 36 (>47) | 47 (>47) |
| 0,16 | S | 40 (35) | 43 (37) | 43 (39) | 43 (39) |

## Beispiel 6

Ein mehrlagiger Aufbau erhöht die Abschirmwirkung. Zur Erhöhung der Absorption, insbesondere auch bei niedrigen Frequenzen, kann eine zwei- oder mehrlagige Anordnung vorteilhaft sein. Zur Steigerung der Abschirmwirkung muß zwischen jeder Metallschicht eine isolierende Zwischenlage sein ; es sind oberflächliche Kaschierungen oder Bedeckungen aus dicht metallisierten nichtleitenden Geweben, Folien oder Lackierungen möglich. Bereits bei einer Doppellage des Gewebes und einer Nickelschichtdicke von etwa 0,40 μm auf jeder Schicht erhöht sich im gesamten Frequenzbereich zwischen 1,7 und 25 GHz die Abschirmung auf über 40 dB. Für meßtechnische Zwecke können Schirmdämpfungen von ca. 100 dB erforderlich sein.

| Zahl der Lagen | Frequenzbereich in GHz | |
| --- | --- | --- |
| | 7 - 8 | 11 - 12 |
| Einfachlage | 21 | 21 |
| Zweifachlage | 33 - 39 | 38 - 43 |
| Dreifachlage | 42 - 48 | 48 - 57 |

Zwischen den Lagen befindet sich eine Lage unmetallisierten Gewebes.

## Beispiel 7

Ein polyacrylnitril folgender Zusammensetzung :

91,1 % Acrylnitril/5,5 % Acrylsäuremethylester
3,4 % Methallylsulfonsäure

wird trocken versponnen. Aus einem Spinnfasergarn der Garnnummer Nm 85/1 aus Spinnfasern dtex 1,6/40 mm Stapellänge, wurde ein Fasergarngewebe hergestellt. Kette und Schuß bestehen aus dem gleichen Material. Das Fasergarngewebe hat folgende Konstruktionsdaten :

| Kreppbindung | Fertigbreite : 144 cm (Rietbreite 155 cm, Rohbreite 148 cm) |
| --- | --- |
| Kette : | 33 Faden/cm roh |
| Schuß : | 30 Faden/cm roh |
| Gewicht : | 84 g/m$^2$ |
| Garnnummer : | Nm 85/2, alpha 115 |
| Stapelfaser : | 1,6 dtex/40 mm, |
| Ausrüstung : | Waschen, Avivieren |

Auf diesem Fasergarngewebe wird bei Raumtemperatur naßchemisch stromlos eine 0,38 μm dicke Nickelschicht niedergeschlagen.

Die Absorption in dB von Mikrowellen in Transmission zeigt folgende Werte :

| Schicht | 1,7-2,4 GHz | 7-8 GHz | 11-12 GHz | 23-24,5 GHz |
| --- | --- | --- | --- | --- |
| I | 25 | 30 (32) | 32 (33,5) | 28,5 (30) |
| II | | 36 (46) | 36 (41) | |
| III | | 29 (38) | 33,5 (40) | |

Während Schicht I die Absorption eines textilen Flächengebildes angibt, das nicht weiter nachbehandelt worden ist, wurde das gleiche Gewebe bei II zusätzlich beidseitig mit·Weich-PVC bei III mit Polyäthylen kaschiert. Auffällig ist die Erhöhung der Schirmwirkung bei Schicht II.

Gewebe dieser Art dürften im medizinischen Bereich zur Abschirmung bestimmter Patienten der Körperoberfläche oder Geräten (z.B. Herzschrittmachern) meist ausreichen.

## Beispiel 8

Ein feiner Baumwoll-Batist der textiltechnischen Konstruktion :

Kette    : 380 Fäden pro 10 cm, ca. 141 dtex (Nm 70/1)
Schuß    : 260 Fäden pro 10 cm, ca. 138 dtex (Nm 70/1)
Bindung : L 1/1

wird wie oben beschrieben bei Raumtemperatur mit Nikkel metallisiert.

Die Absorption in dB von Mikrowellen in Transmission bei einer 0,75 μm Ni-Schicht beträgt :

| 1,7-2,5 GHz | 7-8 GHz | 11-12 GHz | 23-24,5 GHz |
| --- | --- | --- | --- |
| > 25 | 31 (35) | 32,5 (40) | 28 (34,5) |

Die Werte in Kalmmern werden wie in den ersten Beispielen erhalten, wenn das Material in der Objektebene um 90° gedreht wird.

Beispiel 9

19,9 kg Dimethylformamid werden mit 4,8 kg Glyzerin in einem Kessel unter Rühren vermischt. Anschließend werden 5,1 kg eines Acrylnitrilcopolymerisates aus 93,6 % Acrylnitril, 5,7 % Acrylsäuremethylester und 0,7 % Natriummethallylsulfonat unter Rühren zudosiert, 1 Stunde lang bei 80 °C gerührt, filtriert und die fertige Spinnlösung in einem Spinnschacht in an sich bekannter Weise aus einer 180-Loch-Düse trockenversponnen.

Die Schachttemperatur beträgt 160 °C. Die Viskosität der Spinnlösung, welche eine Feststoffkonzentration von 17 % aufweist und die einen Glyzeringehalt von 15,7 Gew.-% — bezogen auf DMF + Polyacrylnitrilpulver — besitzt, beträgt 85 Kugelfallsekunden (Viskositätsbestimmung nach K. Jost, Rheologica Acta Band 1, Nr. 2-3 (1958), Seite 303).

Das Spinngut vom Titer 1 700 dtex wird auf Spulen gesammelt und zu einem Band vom Gesamttiter 102 000 dtex gefacht. Nach Verlassen des Spinnschachtes sind noch 14,1 Gew.-% Glyzerin im Spinnband.

Das Faserkabel wird in kochendem Wasser 1 : 3-fach verstreckt, in siedendem Wasser unter geringer Spannung 3 Minuten lang gewaschen und mit antistatischer Präparation versehen. Dann wird in einem Siebtrommeltrockner unter Zulassung von 20 % Schrumpf bei maximal 130 °C getrocknet und zu Fasern von 60 mm Stapellänge eingeschnitten.

Die Fasern besitzen nach Verlassen des Spinnschachtes, wie rasterelektronenmikroskopische Aufnahmen bei 780- bis 3 800-facher Vergrößerung zeigen, eine ausgesprochene Kern-Mantel-Struktur bei unregelmäßiger, meist trilobaler Querschnittsform.

Die Einzelfasern vom Endtiter 3,3 dtex haben eine Heliumdichte von 1,17 g/cm⁴ und eine Quecksilberdichte von 0,862 g/cm³ bei einem Wasserrückhaltevermögen von 32,8 % und eine Porosität von 26,4 %, die innere Oberfläche beträgt 9,7 m²/g und der mittlere Porendurchmesser 106 nm. Die Saumbreite der Mantelfläche beträgt ca. 4 µm. Durch quantitative Analyse mit dem Bildanalysengerät « Classimat » der Fa. Leitz werden über 100 Faserquerschnitte zur Bestimmung der Kern- bzw. Mantelfläche der Fasern ausgewertet. Danach entfallen im Durchschnitt 32 % der Querschnittsfläche auf die Saumbreite des Mantels.

Die Porenfüllung nach 5 Minuten in Wasser beträgt 71 % (Maximalfüllgrad), jedoch nach 10 Sekunden sind bereits 80 bis 90 % dieses Maximalfüllgrades erreicht.

Die so hergestellte, porenhaltige Acrylnitrilfaser wird anschließend metallisiert : Man stellt ein Flachstrick aus einem Fasergarn Nm 24/1 2-fädig her. Die Konstruktion ist 7 E (englisch Zoll) Teilung, Bindung glattrechts.

Das textile Flächengebilde wird ohne irgendwelche Vorbehandlung direkt in ein kolloidales Palladiumbad bei 18 bis 32 °C mit pH ≤ 1 gegeben. Bereits nach ca. 5 Sekunden ist die Oberfläche gleichmäßig benetzt.

Nach ca. 30 Sekunden entfernt man die Probe, spült gründlich in reinem Wasser bei Raumtemperatur ca. 1 Minute und trägt dann das Material in eine 5 %ige wäßrige Natronlauge bei Raumtemperatur zur Entfernung der Zinn-II- und Zinn-IV-oxidhydrate ein. Nach 2 Minuten Behandlung unter leichter Bewegung spült man wiederum 30 Sekunden gründlich mit reinem Wasser und gibt dann das Flachstrick in eine stabilisierte alkalische Nickelchloridlösung gemäß Beispiel 9 bei Raumtemperatur zur Abscheidung des Nickelmetalls auf die mit Palladium aktivierte Faser- oder Gewebeoberfläche. Bereits nach 20 Sekunden beginnt die Metallabscheidung unter Gasentwicklung und Verfärbung der Faseroberfläche. Nach 5 Minuten sind ca. 0,2 µm Nickel auf der Faseroberfläche fest haftend abgeschieden. Man läßt die Probe insgesamt 20 Minuten im Nickelbad und erhält eine Nickelschicht von ca. 0,75 µm auf der Faseroberfläche, ohne daß der textiltechnische Charakter des Gestricks verloren geht.

Die Absorption von Mikrowellen für eine 0,75 µm Nickelschicht in Transmission beträgt :

| 1,7-2,4 GHz | 7-8 GHz | 11-12 GHz | 23-24,5 GHz |
|---|---|---|---|
| 23 (>25) | 19 (>40) | 18,5 (>40) | 21,5 (>40) |

Bei diesem elastischen Gestrick fällt auch die starke Anisotropie auf.

Ein Rundstrick feinerer Teilung, z.B. ein Fasergarn Nm 40/1 aus dtex 2,2/60 15 E (englisch Zoll) Teilung, Feinripp, Bindung : Rechts/Rechts zeigt folgende Werte der Absorption vom Mikrowellen bei einer 0,75 µm Nickelschicht in Transmission :
(Werte in Dezibel (dB) bei senkrecht einfallender linear polarisierter Strahlung)

| | 1,7-2,4 GHz | 7-8 GHz | 11-12 GHz | 23-24,5 GHz |
|---|---|---|---|---|
| | 17 (12) | 9,7 (18,5) | 9,5 (18,5) | 10,5 (30) |
| S' | >25 (>25) | 32 (>45) | 32 (>45) | 24 (42) |
| S | >25 (>25) | 29 (35) | 31 (35) | 23 (36) |

Werte ohne Klammern bei Vorzugsrichtung (Strickrippe, d.h. Maschenreihen übereinander) senkrecht zum E-Vektor, in Klammern bei Vorzugsrichtung parallel zum E-Vektor.

S = Spannung senkrecht zur Vorzugsrichtung.

S' = Spannung parallel zur Vorzugsrichtung.

## Beispiel 10

Ein Fasergarngestrick einer textiltechnischen Konstruktion — wie in Beispiel 2 beschrieben — wird verkupfert.

Die Absorption von Mikrowellen bei einer 0,9 μm dicken Kupferschicht in Transmission zeigte folgende Werte:

| | | 1,7–2,4 GHz | 7–8 GHz | 11–12 GHz | 23–24,5 GHz |
|---|---|---|---|---|---|
| | a | 32 (35) | 25 (31) | 25 (35) | 24 (35) |
| | b | | 26 (31,5) | 26,5 (37) | 26,5 (37) |
| S' | a | 37 (40) | 38 (40) | 39 (42) | 33 (41) |
| | b | | 40 (42) | 40 (44,5) | 35 (43,5) |
| S | a | 40 (>40) | 35 (40) | 32,5 (45) | 29 (45) |
| | b | | 37 (42) | 33,5 (45) | 30,5 (46,5) |

a = Einfallwinkel der Strahlung 0°.
b = Einfallwinkel der Strahlung 30°.

## Beispiel 11

Auf einem Fasergarngestrick wird ähnlich wie in Beispiel 10 eine 0,2 μm dicke Kupferschicht stromlos abgeschieden. Daran anschließend wird darauf stromlos eine 0,35 μm dicke Goldschicht abgeschieden. Die Absorption eines solchen metallisierten Gestricks zeigt folgende Werte in dB:

| | | 1,7–2,4 | 7 – 8 | 11 – 12 | 23 – 24,5 |
|---|---|---|---|---|---|
| | a | 25 (25) | 15,5 (24,5) | 19,5 (26,5) | 22 (35) |
| | b | | 16,5 (26,0) | 21 (28,5) | 33,5 (37) |
| S' | a | 25 (30) | 26 (35) | 33 (38) | 29 (39,5) |
| | b | | 27 (37) | 34 (34,5) | 30,5 (41,5) |
| S | a | 25 (35) | 27 (37) | 32,5 (38) | 32,5 (41) |
| | b | | 27 (37) | 34 (38,5) | 33 (43) |

S' = Spannung parallel zu den Strickrippen.
S = Spannung senkrecht zu den Strickrippen.
a = Einfallswinkel der Strahlung 0°.
b = Einfallswinkel der Strahlung 30°.

## Beispiel 12

Ein nach Beispiel 2 stromlos vernickeltes Filamentgarngewebe wird nach in der Kunststoffgalvanik üblichen Verfahren metallisiert. Auf die stromlos abgeschiedene Nickelschicht von 0,3 μm wird

# 0 010 712

galvanisch eine Nickelschicht von 1 μm Dicke abgeschieden.

Bei senkrechter Inzidenz wird im Bereich von 1,7-12 GHz eine Schirmdämpfung von mehr als 40 dB erzielt.

Besondere Anwendungsgebiete ergeben sich für das elastische, metallisierte Material im medizinischen und im gerätetechnischen Bereich. Es ist einerseits möglich, die Dezimeter- und Mikrowellengeräte mit dem metallisierten, elastischen Material abzuschirmen bzw. abzudecken, das metallisierte, elastische Material kann aber auch vom Bedienungs- und Wartungspersonal getragen werden. Durch entsprechende Auswahl eines leichten textilen Gewebes ist das Personal kaum behindert. Ebenso können am Patienten mit diesem Material Bereiche abgedeckt werden, die nicht bestrahlt werden sollen. Zur Erhöhung der Abriebbeständigkeit kann das elastische metallisierte Material lackiert, mit üblichen Avivagen präpariert, mit PVC-Weichmacherkombinationen kaschiert oder z.B. mit Polyäthylenfolien kalandriert sein.

Das metallisierte, elastische Material ist auch besonders geeignet zur Umhüllung von Industrie- und Haushaltsgeräten, die Hochfrequenzstrahlung abstrahlen (wie beispielsweise Mikrowellenbackofen, Mikrowellentrockner und Erwärmungsgeräte) und auch von solchen Geräten, die durch Hochfrequenzstrahlung nicht gestört werden dürfen, z.B. Herzschrittmacher. Es ist auch möglich, metallisierte Fasern oder Gewebe bei der Herstellung von Kunststoffgehäusen in die Gehäusewand einzuarbeiten. Zur Herstellung von geschirmten Räumen müssen alle Flächen elektrisch untereinander leitend verbunden sein. Spalten oder Fugen müssen elektrisch abgedichtet sein. Das erfindungsgemäße, elastische, metallisierte Material ist gerade auch als Dichtungsprofil besonders geeignet. Es kann beispielsweise in Form von metallisierten Garnen, Zwirnen oder Schnüren in die Spalten oder Dichtungsnuten gedrückt werden und verhindert dadurch wirkunsvoll eine Emission oder Imission hochfrequenter Strahlung. Solche Dichtungsprofile sind elastischer, leichter, handhabbarer und anpassungsfähiger als metallische Dichtungsprofile.

## Ansprüche

1. Metallisierte textile Flächengebilde aus synthetischen Polymeren oder nativen Fasern, die senkrecht zur Abschirmungsrichtung, Öffnungen mit Werten kleiner als die halbe Wellenlänge der abzuschirmenden Strahlung aufweisen, wobei das Metall nach Aktivierung der textilen Flächengebilde, auf diesen mit einer Metallschichtdicke auf dem Monofil zwischen 0,02 und 2 μm naßchemisch stromlos niedergeschlagen worden ist, zur Abschirmung von Mikrowellen- und Hochfrequenzstrahlung im Bereich von 0,01 bis 1 000 GHz.

2. Metallisierte textile Flächengebilde nach Anspruch 1, gekennzeichnet durch eine Metallschicht aus Nickel, Kobalt, Kupfer, Silber, Gold, auch in Kombination oder als Legierung.

3. Metallisierte textile Flächengebilde nach den Anprüchen 1 und 2, dadurch gekennzeichnet, daß die textilen Flächengebilde aus Baumwolle, Polyacrylnitril, Polyamid, Aramid, Polyester, Viskose, Polyolefin, Modacryl, Polyurethan, PVC, alleine oder auch untereinander oder in Mischung miteinander kombiniert bestehen.

4. Metallisierte textile Flächengebilde nach den Ansprüchen 1 bis 3, dadurch gekennzeichnet, daß die metallisierten textilen Flächengebilde nach ihrer Metallisierung mehrlagig angeordnet sind, wobei isolierende Zwischenlagen oder oberflächliche Kaschierungen oder Bedeckungen aus nicht-metallisierten Geweben, Folien oder Lackierungen zwischen den einzeln metallisierten Schichten eingeschoben sind.

5. Metallisierte textile Flächengebilde nach den Ansprüchen 1 bis 4, gekennzeichnet durch elastische textile Flächengebilde mit isotropen Eigenschaften.

6. Metallisierte textile Flächengebilde nach den Ansprüchen 1 bis 4, gekennzeichnet durch metallisierte elastische textile Flächengebilde, die einachsig spannbar sind.

7. Metallisierte textile Flächengbilde nach den Ansprüchen 1 bis 6, gekennzeichnet durch eine zusätzlich galvanisch aufgebrachte Metallschicht.

8. Verwendung von metallisierten textilen Flächengebilden nach den Ansprüchen 1 bis 7 als Strahlenschutz im medizinischen und nachrichtentechnischen Bereich.

9. Verwendung von metallisierten textilen Flächengebilden nach den Ansprüchen 1 bis 7 zur Abschirmung von Kunststoffgehäusen und als Dichtungsprofil zur elektrischen Abdichtung.

## Claims

1. Metallised sheet-form textiles of synethic polymers or natural fibres, which have openings which are perpendicular to the direction of screening and have widths which are less than half the wavelength of the radiation to be screened, the metal having been applied by wet-chemical currentless deposition to the sheet-form textile after activation thereof in a metal layer thickness on the monofilament of between 0.02 and 2 μm, for screening microwave and high-frequency radiation in the range from 0.01 to 1 000 GHz.

2. Metallised sheet-form textiles according to Claim 1, characterised by a metal layer of nickel, cobalt, copper, silver, gold, even in combination or in alloyed form.

3. Metallised sheet-form textiles according to Claims 1 and 2, characterised in that the sheet-form textiles consist of cotton, polyacrylonitrile, polyamide, aramide, polyester, viscose, polyolefin, modacrylic, polyurethane, PVC, either individually or even in combination or in admixture with one another.

4. Metallised sheet-form textiles according to Claims 1 to 3, characterised in that after metallisation the metallised sheet-form textiles are arranged in several layers, insulating intermediate layers or surface linings or coverings of non-metallised fabrics, films or lacquers being arranged between the individual metallised layers.

5. Metallised sheet-form textiles according to Claims 1 to 5, characterised by elastic sheet-form textiles having isotropic properties.

6. Metallised sheet-form textiles according to Claims 1 to 4, characterised by metallised elastic sheet-form textiles which are mono-axially stretchable.

7. Metallised sheet-form textiles according to Claims 1 to 6, characterised by an additional metal layer applied by electrodeposition.

8. The use of metallised sheet-form textiles according to Claims 1 to 7 for protection against radiation in the medical and communications fields.

9. The use of metallised sheet-form textiles according to claims 1 to 7 for screening plastics housings and as sealing profiles for electrical sealing.

**Revendications**

1. Articles textiles superficiels métallisés constitués de polymères synthétiques ou de fibres naturelles, comportant, perpendiculairement au sens de la protection à assurer, des ouvertures d'une largeur inférieure à la demi-longueur d'onde du rayonnement contre lequel une protection doit être assurée, le métal étant, après activation de l'article textile superficiel, précipité sur ce dernier sans courant et chimiquement par voie humide en formant, sur le monofil, une couche métallique d'une épaisseur de 0,02 à 2 µm afin d'assurer une protection contre les rayonnements à micro-ondes et à haute fréquence se situant dans la gamme de 0,01 à 1 000 GHz.

2. Articles textiles superficiels métallisés suivant la revendication 1, caractérisés en ce qu'ils comportent une couche métallique de nickel, de cobalt, de cuivre, d'argent, d'or, également en combinaison ou sous forme d'un alliage.

3. Articles textiles superficiels métallisés suivant les revendications 1 et 2, caractérisés en ce que les articles textiles superficiels sont constitués de coton, de polyacrylonitrile, de polyamide, d'aramide, de polyester, de viscose, d'une polyoléfine, de fibres modacryliques, de polyuréthane, de chlorure de polyvinyle, individuellement ou également combinés entre eux ou en mélange l'un avec l'autre.

4. Articles textiles superficiels métallisés suivant les revendications 1 à 3, caractérisés en ce que, après leur métallisation, ils sont disposés en plusieurs couches, des couches intermédiaires isolantes ou des recouvrements ou des doublages superficiels constitués de vernis, de feuilles ou de tissus non métallisés étant intercalés entre les différentes couches métallisées.

5. Articles textiles superficiels métallisés suivant les revendications 1 à 4, caractérisés en ce qu'il s'agit d'articles textiles superficiels élastiques ayant des propriétés isotropes.

6. Articles textiles superficiels métallisés suivant les revendications 1 à 4, caractérisés en ce qu'il s'agit d'articles textiles superficiels élastiques métallisés pouvant être soumis à une tension monoaxiale.

7. Articles textiles superficiels métallisés suivant les revendications 1 à 6, caractérisés en ce qu'ils comportent une couche métallique supplémentaire appliquée par voie galvanique.

8. Utilisation d'articles textiles superficiels métallisés suivant les revendications 1 à 7, comme protection contre les radiations dans le domaine médical et le domaine de la technique de l'information.

9. Utilisation d'articles textiles superficiels métallisés suivant les revendications 1 à 7, en vue d'assurer un blindage de protection pour les logements en matières synthétiques et comme profilés d'étanchéité en vue d'assurer une étanchéité électrique.